# DEMANDE DE BREVET EUROPEEN

(11) **EP 3 922 690 A1**
(43) Date de publication de la demande: **15.12.2021**
(21) Numéro de dépôt: 21178127.3
(22) Date de dépôt: 08.06.2021
(51) Int. Cl.: C09J 5/04, H01L 21/762

(54) **PROCÉDÉ DE COLLAGE TEMPORAIRE**

(30) Priorité: 09.06.2020 FR 2006027
(71) Demandeur: Commissariat à l'Energie Atomique et aux Energies Alternatives, 75015 Paris (FR)
(72) Inventeur: MONTMEAT, Pierre, 38054 GRENOBLE CEDEX 09 (FR); FOURNEL, Frank, 38054 GRENOBLE CEDEX 09 (FR); BALLY, Laurent, 38054 GRENOBLE CEDEX 09 (FR); ENOT, Thierry, 38054 GRENOBLE CEDEX 09 (FR)
(74) Mandataire: Cabinet Beaumont

(57) **Abrégé**

La présente description concerne un procédé de collage temporaire d'un objet (10) ayant des première et deuxième faces opposées (14, 16) comprenant successivement le collage de l'objet à une poignée (20) du côté de la première face (14), le collage de l'objet à un premier film adhésif (40) du côté de la deuxième face, le collage du premier film adhésif à un deuxième film adhésif (50) du côté opposé à l'objet, et le retrait de la poignée par rapport à l'objet.

## Description

### Domaine technique

La présente demande concerne un procédé de collage temporaire d'un objet, notamment une plaque de composants électriques.

### Technique antérieure

Les dimensions de certains objets rendent difficiles leur manipulation directe pour réaliser un traitement. C'est le cas notamment pour un objet fin, par exemple une plaque ayant une épaisseur inférieure à 200 µm. Pour manipuler un tel objet, il est connu de coller cet objet à un support, appelé également poignée, de façon à effectuer le traitement voulu, puis de décoller l'objet de la poignée à la fin du traitement. L'objet peut être fixé à un cadre rigide par l'intermédiaire d'un film adhésif pour permettre le détachement de la poignée. Un film adhésif comprend un film support recouvert d'une couche de colle.

L'objet peut comprendre des reliefs du côté fixé au film adhésif. Lorsque l'objet correspond à une plaque, les reliefs peuvent correspondre à des composants électriques formés sur la face de la plaque fixée au film adhésif. La couche de colle du film adhésif doit alors avoir une épaisseur suffisante pour encapsuler les reliefs afin d'obtenir une adhésion suffisante de l'objet au film adhésif. Toutefois, si l'épaisseur de colle est trop importante, elle peut venir au contact de la poignée et gêner, voire empêcher, le détachement de la poignée.

### Résumé de l'invention

Ainsi, un objet d'un mode de réalisation est de pallier au moins en partie les inconvénients des procédés de collage temporaires décrits précédemment.

Un autre objet d'un mode de réalisation est que l'objet peut présenter des reliefs ayant une hauteur supérieure à plusieurs micromètres.

Un mode de réalisation prévoit un procédé de collage temporaire d'un objet ayant des première et deuxième faces opposées comprenant successivement le collage de l'objet à une poignée du côté de la première face, le collage de l'objet à un premier film adhésif du côté de la deuxième face, le collage du premier film adhésif à un deuxième film adhésif du côté opposé à l'objet, et le retrait de la poignée par rapport à l'objet.

Selon un mode de réalisation, le premier film adhésif comprend un premier film support recouvert d'une première couche de colle, le collage de l'objet au premier film adhésif étant effectué du côté de la première couche de colle, la première couche de colle venant au contact de la poignée après le collage de l'objet au premier film adhésif.

Selon un mode de réalisation, l'épaisseur de la première couche de colle est comprise entre 10 µm et 300 µm.

Selon un mode de réalisation, l'épaisseur du premier film support est comprise entre 50 µm et 500 µm.

Selon un mode de réalisation, le deuxième film adhésif comprend un deuxième film support recouvert d'une deuxième couche de colle, le collage du premier film adhésif au deuxième film adhésif étant effectué du côté du premier film support et de la deuxième couche de colle, la deuxième couche de colle ne venant pas au contact de la poignée après le collage du premier film adhésif au deuxième film adhésif.

Selon un mode de réalisation, l'objet comprend une plaque de silicium.

Selon un mode de réalisation, l'objet comprend des composants électriques au moins en partie en relief de la deuxième face.

Selon un mode de réalisation, le procédé comprend une étape d'amincissement de l'objet après le collage de l'objet à la poignée et avant le collage de l'objet au premier film adhésif.

Selon un mode de réalisation, le procédé comprend une étape de découpe de la partie périphérique du premier film adhésif après le collage de l'objet au premier film adhésif et avant le collage du premier film adhésif au deuxième film adhésif pour libérer le pourtour de la poignée.

Selon un mode de réalisation, l'étape de découpe est réalisée au moyen d'une lame coupante ou d'une scie diamantée.

Selon un mode de réalisation, le procédé comprend une étape de retrait des parties de la première couche de colle au contact de la poignée, après le collage de l'objet au premier film adhésif et avant le collage du premier film adhésif au deuxième film adhésif.

Selon un mode de réalisation, l'étape de retrait des parties de la première couche de colle au contact de la poignée comprend une étape d'attaque chimique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est une vue en coupe, partielle et schématique, de la structure obtenue à une étape d'un exemple d'un procédé de collage temporaire d'une plaque ;
la figure 1B illustre une autre étape du procédé ;
la figure 1C illustre une autre étape du procédé ;
la figure 1D illustre une autre étape du procédé ;
la figure 1E illustre une autre étape du procédé ;
la figure 1F illustre une autre étape du procédé ;
la figure 1G illustre une autre étape du procédé ;
la figure 2 est une vue en coupe, partielle et schématique, de la structure obtenue à une étape d'un exemple d'un procédé de collage temporaire illustrant un inconvénient du procédé de collage ;
la figure 3A est une vue en coupe, partielle et schématique, de la structure obtenue à une étape d'un mode de réalisation d'un procédé de collage temporaire d'une plaque ;
la figure 3B illustre une autre étape du procédé ;
la figure 3C illustre une autre étape du procédé ; et
la figure 3D illustre une autre étape du procédé.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés. En particulier, les procédés de détachement d'une poignée sont connus de l'homme du métier et ne sont pas décrits en détail.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un dispositif optoélectronique dans une position normale d'utilisation. Sauf précision contraire, les expressions "environ", "approximativement", "sensiblement", et "de l'ordre de" signifient à 10 % près, de préférence à 5 % près.

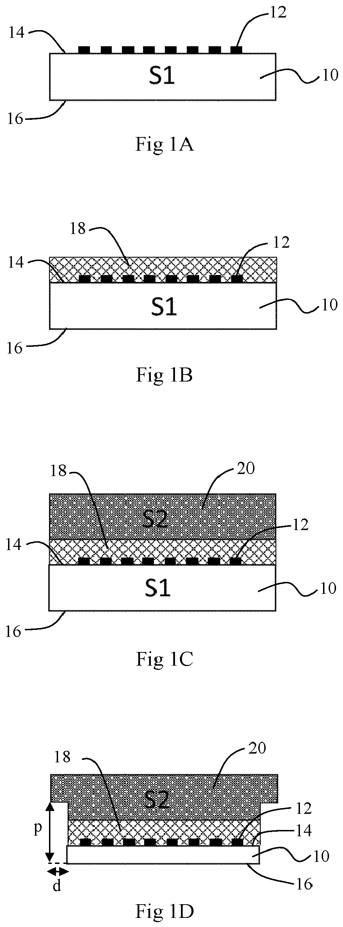

Les figures 1A à 1G sont des vues en coupe, partielles et schématiques, de structures obtenues à des étapes successives d'un exemple d'un procédé de collage temporaire d'un objet 10 (S1), notamment une plaque de silicium.

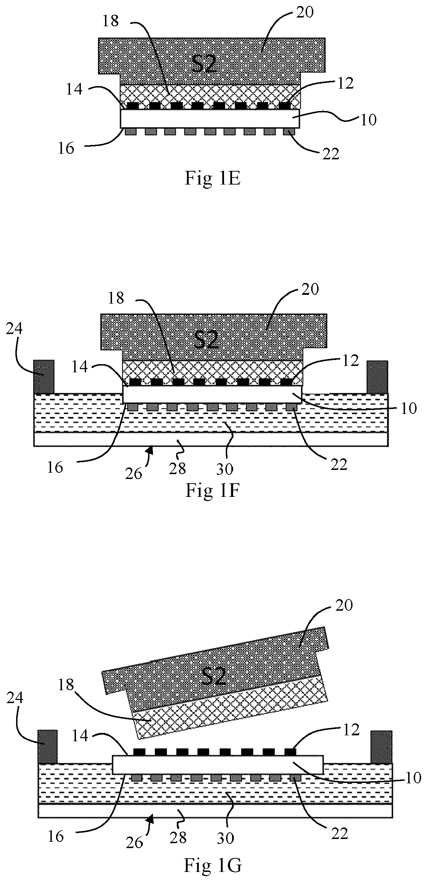

Le procédé comprend les étapes successives suivantes :
- fabrication de composants électriques 12 sur la plaque 10 et dans la plaque 10, la plaque 10 comprenant des faces supérieure et inférieure opposées 14 et 16, les composants électriques 12 étant situés du côté de la face supérieure 14 (figure 1A) ;
- fixation d'une couche de colle 18 adhérant aux composants électriques 12 et à la face supérieure 14 de la plaque 10 entre les composants électriques 12 (figure 1B) ;
- fixation d'une poignée 20 (S2), par exemple une autre plaque de silicium, à la couche de colle 18, du côté de la couche de colle 18 opposé à la plaque 10 (figure 1C) ;
- amincissement de la plaque de silicium 10 du côté de la face inférieure 16 et détourage de la plaque de silicium 10 et éventuellement d'une partie de la poignée 20 (figure 1D) ;
- formation de composants électriques 22 sur la plaque de silicium 10 amincie et dans la plaque de silicium 10 amincie, les composants électriques 22 étant situés du côté de la face inférieure 16 (figure 1E) ;
- fixation de l'ensemble comprenant la plaque 10 et la poignée 20 à un cadre 24 rigide par l'intermédiaire d'un film adhésif 26, le film adhésif 26 comprenant un film support 28 recouvert d'une couche de colle 30 (figure 1F) ; et
- retrait de la poignée 20 (figure 1G).

Des traitements peuvent être réalisés ultérieurement sur la plaque 10. Selon un exemple, la plaque 10 peut être découpée.

Au moins certains des composants électriques 22 présents sur la face inférieure 16 de la plaque 10 peuvent avoir une hauteur supérieure à plusieurs micromètres, notamment supérieure à 10 µm, par rapport à la face inférieure 16. Pour protéger ces composants 22 lors de la fixation de l'ensemble comprenant la plaque 10 et la poignée 20 sur le cadre 24 au moyen du film adhésif 26, et pour assurer une adhésion convenable de l'ensemble comprenant la plaque 10 et la poignée 20 au cadre 24, il est nécessaire que l'épaisseur de la couche de colle 30 soit suffisante pour encapsuler complètement les composants 22.

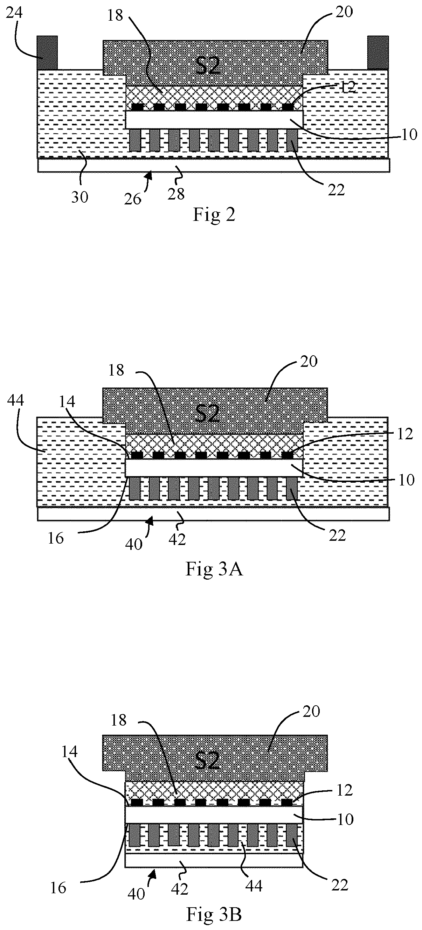

La figure 2 est une vue en coupe, partielle et schématique, analogue à la figure 1F illustrant le cas où une couche de colle 30 ayant une épaisseur élevée est utilisée, notamment en raison des dimensions des composants électriques 22. Comme cela apparaît sur cette figure, le bord de la poignée 20 peut venir au contact de la couche de colle 30 du film adhésif 26. Le retrait de la poignée 20 par rapport à la plaque 10 peut alors ne pas être possible.

Les figures 3A à 3D sont des vues en coupe, partielles et schématiques, de structures obtenues à des étapes successives d'un mode de réalisation d'un procédé de collage temporaire d'un objet, notamment une plaque de silicium.

Les étapes initiales du procédé peuvent correspondre aux étapes décrites précédemment en relation avec les figures 1A à 1E.

En particulier, la plaque 10 peut avoir une forme cylindrique avec un diamètre compris entre 25,4 mm et 450 mm, par exemple égal à environ 300 mm. L'épaisseur de la plaque 10 avant amincissement peut être comprise entre 300 µm et 2000 µm, par exemple égale à environ 775 pm. En outre, la poignée 20 peut avoir une forme cylindrique de diamètre compris entre 25,4 mm et 450 mm, par exemple égal à environ 300 mm. L'épaisseur de la poignée 20 peut être comprise entre 300 µm et 2000 µm, par exemple égale à environ 775 µm. Les composants électriques 12, 22 peuvent être des composants de circuits électroniques. Plusieurs circuits électroniques peuvent être formés sur la plaque 10, par exemple plusieurs exemplaires d'un même circuit électronique.

De plus, à l'étape de collage décrite précédemment en relation avec les figures 1B et 1C, la couche de colle 18 peut comprendre un polymère ou un mélange de polymères, notamment des polymères oléfines cycliques, époxy, acryliques, styréniques, halogénures de vinyle, esters vinyliques, polyamides, polyimides, polysulfones, polyéthersulfones, caoutchoucs de polyoléfine, polyuréthanes, caoutchoucs éthylène-propylène, esters de polyamide, esters de polyimides, et polyacétals. A titre d'exemple, la couche de colle 18 peut correspondre au produit commercialisé par Brewer Science sous l'appellation BrewerBOND^{®}305. L'épaisseur de la couche de colle 18 peut être comprise entre 1 µm et 100 µm, par exemple égale à 20 µm. Selon un mode de réalisation, la couche de colle 18 peut être étalée sur la face 14 par enduction centrifuge dans le cas d'une formulation de colle liquide. La couche de colle 18 peut aussi être disponible sous forme de film sec et dans ce cas elle est disposée sur un film support, non représenté, l'ensemble étant appliqué sur la face supérieure 14 de la plaque 10 du côté de la couche de colle 18, et le film support étant retiré, notamment par délamination. Une couche antiadhésive destinée à faciliter le démontage entre la poignée 20 et la couche de colle 18 peut être formée au préalable sur la face de la poignée 20 destinée à venir au contact de la couche de colle 18. Cette couche antiadhésive est par exemple une couche du produit fluoré commercialisé par la société 3M sous l'appellation 3M^{™}Novec^{™}2702. La poignée 20 est appliquée contre la couche de colle 18, et la cohésion de la couche de colle 18 est réalisée par chauffage, par exemple à une température de l'ordre de 200 °C.

De plus, les étapes décrites précédemment en relation avec la figure 1D peuvent comprendre une étape d'amincissement de la plaque 10. L'épaisseur de la plaque 10 après l'étape d'amincissement peut être comprise entre 20 µm et 300 µm, par exemple égale à environ 50 µm. L'étape d'amincissement de la plaque 10 peut être réalisée au moyen d'une roue diamantée.

En outre, les étapes décrites précédemment en relation avec la figure 1D peuvent comprendre une étape de détourage de l'ensemble comprenant la plaque 10 et la poignée 20, c'est-à-dire le retrait d'une partie de l'ensemble comprenant la plaque 10 et la poignée 20 sur tout ou partie de la périphérie de l'ensemble comprenant la plaque 10 et la poignée 20. Ceci permet notamment de réduire, voire de supprimer, l'écaillage de la plaque 10 lorsqu'elle est amincie. L'étape de détourage peut comprendre le retrait d'une partie de la plaque 10 sur toute la périphérie de la plaque 10 sur une distance d comprise entre 0,5 mm et 5 mm et/ou sur une profondeur p comprise entre 30 µm et 300 µm. L'étape de détourage peut être réalisée au moyen d'une scie diamantée.

La figure 3A représente la structure obtenue après la fixation d'un premier film adhésif 40 à l'ensemble comprenant la plaque 10 et la poignée 20. Le premier film adhésif 40 est fixé à l'ensemble comprenant la plaque 10 et la poignée 20 du côté de la face inférieure 16 de la plaque 10. Le premier film adhésif 40 comprend un film support 42 recouvert d'une couche de colle 44, la couche de colle 44 venant au contact de l'ensemble comprenant la plaque 10 et la poignée 20 lors de la fixation du film adhésif 40. L'épaisseur de la couche de colle 44 est suffisante pour encapsuler complètement les composants électriques 22. La couche de colle 44 peut venir au contact de la poignée 20 comme cela est représenté en figure 3A. Le premier film adhésif 40 peut être fixé à l'ensemble comprenant la plaque 10 et la poignée 20 par lamination, c'est-à-dire par mise en contact du premier film adhésif 40, du côté de la couche de colle 44, avec l'ensemble comprenant la plaque 10 et la poignée 20 avec application d'une pression et éventuellement sous vide.

La couche de colle 44 du premier film adhésif 40 peut comprendre un polymère ou un mélange de polymères, notamment des polymères oléfines cycliques, époxy, acryliques, styréniques, halogénures de vinyle, esters vinyliques, polyamides, polyimides, polysulfones, polyéthersulfones, caoutchoucs de polyoléfine, polyuréthanes, caoutchoucs éthylène-propylène, esters de polyamide, esters de polyimides, et polyacétals. L'épaisseur de la couche de colle 44 peut être comprise entre 10 µm et 300 µm, par exemple égale à environ 130 µm. Le film support 42 peut comprendre un polymère ou un mélange de polymères, notamment le polyéthylène téréphtalate (PET), polyéthylène téréphtalate traité à la silicone, polyimide, polyéthylène, polyoléfine, et polycarbonate. L'épaisseur du film support 42 peut être comprise entre 50 µm et 500 µm, par exemple égale à 100 µm. A titre d'exemple, le premier film adhésif 40 peut correspondre au produit commercialisé par Furukawa Electric sous l'appellation Furukawa SP-537T-230 ou au produit commercialisé par Lintec Corporation sous l'appellation Adwill D-650.

La figure 3B représente la structure obtenue après une opération de découpe du premier film adhésif 40 pour libérer le pourtour de la poignée 20. Une opération de nettoyage peut en outre être réalisée pour retirer les parties de la couche de colle 44 éventuellement au contact de la poignée 20. L'étape de découpe du premier film adhésif 40 peut être réalisée au moyen d'une lame coupante ou d'une scie diamantée. L'étape de nettoyage peut être réalisée par attaque chimique des parties de la couche de colle 44 éventuellement au contact de la poignée 20, par exemple en utilisant un solvant adapté, notamment du limonène.

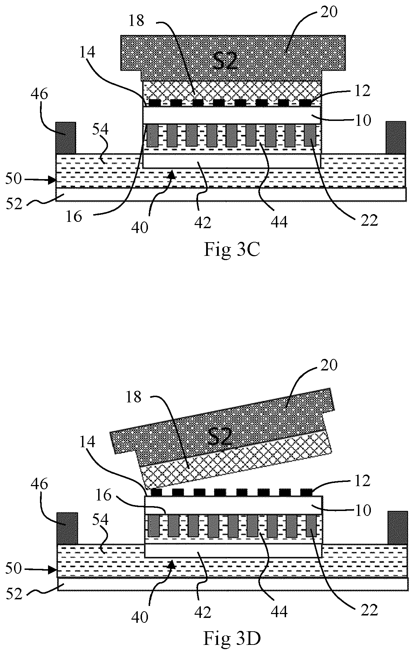

La figure 3C représente la structure obtenue après une fixation de l'ensemble comprenant la plaque 10, la poignée 20 et le premier film adhésif 40 à un cadre 46 rigide par l'intermédiaire d'un deuxième film adhésif 50. Le deuxième film adhésif 50 comprend un film support 52 recouvert d'une couche de colle 54. L'ensemble est orienté pour que le film support 42 du premier film adhésif 40 vienne au contact de la couche de colle 54 du deuxième film adhésif 50. Comme le film support 42 du premier film adhésif 40 est sensiblement plan, l'épaisseur de la couche de colle 54 du deuxième film adhésif 50 peut être inférieure à l'épaisseur de la couche de colle 44 du premier film adhésif 40. Toutefois, l'épaisseur de la couche de colle 54 du deuxième film adhésif 50 peut être égale ou supérieure à l'épaisseur de la couche de colle 44 du premier film adhésif 40 tant que la couche de colle 54 du deuxième film adhésif 50 ne vient pas au contact de la poignée 20. L'épaisseur de la couche de colle 54 du deuxième film adhésif 50 peut être comprise entre 10 µm et 150 µm. La couche de colle 54 du deuxième film adhésif 50 peut être dans l'un des matériaux décrits précédemment pour la couche de colle 44 du premier film adhésif 40. Le film support 52 du deuxième film adhésif 50 peut être dans l'un des matériaux décrits précédemment pour le film support 42 du premier film adhésif 40. A titre d'exemple, le premier film adhésif 40 peut correspondre au produit commercialisé par Furukawa Electric sous l'appellation Furukawa SP-537T-230 ou au produit commercialisé par Lintec Corporation sous l'appellation Adwill D-650.

La figure 3D représente la structure obtenue après le retrait de la poignée 20 par rapport à la plaque 10. Le retrait de la poignée 20 peut être réalisé par une action mécanique ou par une action mécanique associée à une action chimique ou par une action mécanique associée à une irradiation laser.

Des traitements peuvent ultérieurement être réalisés sur la plaque 10. Selon un exemple, la plaque 10 peut être découpée, par exemple pour séparer les circuits électroniques formés sur la plaque 10, les films adhésifs 40 et 50 et le cadre 46 permettant de maintenir la plaque 10 pendant l'opération de découpe. Selon un autre exemple, la plaque 10 ou les portions découpées de la plaque 10 peuvent être détachées du premier film adhésif 40. Le procédé de séparation va dépendre de la nature de ce film adhésif : dans le cas d'un polymère réticulable aux UV (acrylate), une insolation UV permet de diminuer son adhésion, dans le cas d'un polymère sensible à la température, un recuit permet de dégrader l'adhésif et de diminuer son adhésion.

Divers modes de réalisation et variantes ont été décrits. Selon un autre mode de réalisation, l'étape de détourage de la plaque 10 peut ne pas être réalisée, comme cela a été décrit précédemment en relation avec la figure 1D, juste après l'amincissement de la plaque 10, mais être réalisée avant les étapes décrites précédemment en relation avec la figure 1B, c'est-à-dire avant le dépôt de la couche de colle 18. En outre, bien que la poignée 20 ait été décrite comme pouvant être une plaque de silicium, il est clair que la poignée 20 peut être en n'importe quel matériau permettant le collage de la poignée 20 à la plaque 10 et la manipulation de la plaque 10. La personne du métier comprendra que certaines caractéristiques de ces divers modes de réalisation et variantes pourraient être combinées, et d'autres variantes apparaîtront à la personne du métier. Enfin, la mise en oeuvre pratique des modes de réalisation et variantes décrits est à la portée de la personne du métier à partir des indications fonctionnelles données ci-dessus.

## Revendications

1. Procédé de collage temporaire d'un objet (10) ayant des première et deuxième faces opposées (14, 16) comprenant successivement le collage de l'objet à une poignée (20) du côté de la première face (14), le collage de l'objet à un premier film adhésif (40) du côté de la deuxième face, le collage du premier film adhésif à un deuxième film adhésif (50) du côté opposé à l'objet, et le retrait de la poignée par rapport à l'objet.

2. Procédé selon la revendication 1, dans lequel le premier film adhésif (40) comprend un premier film support (42) recouvert d'une première couche de colle (44), le collage de l'objet (10) au premier film adhésif (40) étant effectué du côté de la première couche de colle, la première couche de colle venant au contact de la poignée (20) après le collage de l'objet (10) au premier film adhésif (40).

3. Procédé selon la revendication 2, dans lequel l'épaisseur de la première couche de colle (44) est comprise entre 10 µm et 300 µm.

4. Procédé selon la revendication 2 ou 3, dans lequel l'épaisseur du premier film support (42) est comprise entre 50 µm et 500 µm.

5. Procédé selon l'une quelconque des revendications 2 à 4, dans lequel le deuxième film adhésif (50) comprend un deuxième film support (52) recouvert d'une deuxième couche de colle (54), le collage du premier film adhésif (40) au deuxième film adhésif (50) étant effectué du côté du premier film support (42) et de la deuxième couche de colle, la deuxième couche de colle ne venant pas au contact de la poignée (20) après le collage du premier film adhésif (40) au deuxième film adhésif (50).

6. Procédé selon l'une quelconque des revendications 1 à 5, dans lequel l'objet (10) comprend une plaque de silicium.

7. Procédé selon la revendication 6, dans lequel l'objet (10) comprend des composants électriques au moins en partie en relief de la deuxième face.

8. Procédé selon l'une quelconque des revendications 1 à 7, comprenant une étape d'amincissement de l'objet (10) après le collage de l'objet à la poignée (20) et avant le collage de l'objet au premier film adhésif (40).

9. Procédé selon l'une quelconque des revendications 1 à 8, comprenant une étape de découpe de la partie périphérique du premier film adhésif (40) après le collage de l'objet au premier film adhésif et avant le collage du premier film adhésif au deuxième film adhésif (50) pour libérer le pourtour de la poignée (20).

10. Procédé selon la revendication 9, dans lequel l'étape de découpe est réalisée au moyen d'une lame coupante ou d'une scie diamantée.

11. Procédé selon la revendication 9 ou 10 dans son rattachement à la revendication 2, comprenant une étape de retrait des parties de la première couche de colle (44) au contact de la poignée (20), après le collage de l'objet (10) au premier film adhésif (40) et avant le collage du premier film adhésif au deuxième film adhésif (50).

12. Procédé selon la revendication 11, dans lequel l'étape de retrait des parties de la première couche de colle (44) au contact de la poignée (20) comprend une étape d'attaque chimique.
